# EUROPÄISCHE PATENTSCHRIFT

(11) **EP 0 250 721 B1**
(45) Veröffentlichungstag und Bekanntmachung des Hinweises auf die Patenterteilung: **15.09.1993**
(21) Anmeldenummer: 87104507.6
(22) Anmeldetag: 26.03.1987
(51) Int. Cl.: H01L 27/06, H01L 21/82

(54) **Integrierte Bipolar- und komplementäre MOS-Transistoren auf einem gemeinsamen Substrat enthaltende Schaltung und Verfahren zu ihrer Herstellung**
Integrated circuit comprising bipolar and complementary MOS transistors on a common substrate, and production method
Circuit intégré comprenant sur un substrat commun des transistors bipolaires et des transistors MOS complémentaires et son procédé de fabrication

(30) Priorität: 04.07.1986 DE 3622525
(43) Veröffentlichungstag der Anmeldung: 07.01.1988
(73) Patentinhaber: SIEMENS AKTIENGESELLSCHAFT, 80333 München (DE)
(72) Erfinder: Winnerl, Josef, Dr., D-8300 Landshut (DE); Neppl, Franz, Dr., D-8000 München 90 (DE)

(56) Entgegenhaltungen:
- EP-A- 0 101 000
- EP-A- 0 139 266
- EP-A- 0 215 583
- US-A- 4 074 304

## Beschreibung

Die Erfindung betrifft ein Verfahren zum Herstellen einer mindestens einen Bipolartransistor, einen n-Kanal-MOS-Transistor und einen dazu komplementären p-Kanal-MOS-Transistor auf einem gemeinsamen Substrat enthaltenden Schaltung, bei der die Emitter- und Basisanschlüsse der Bipolartransistoren, sowie die Gateelektroden der MOS-Transistoren mindestens teilweise aus einem dotierten Silizid eines hochschmelzenden Metalles bestehen.

Eine solche integrierte Schaltung und ein Verfahren zu deren Herstellung ist bereits in der nachveröffentlichten deutschen Patentanmeldung DE-A-35 32 817 vorgeschlagen worden. Durch die Verwendung des Silizids wird nicht nur gegenüber den herkömmlichen Verfahren eine Implantationsmaske eingespart, sondern es wird auch eine Unabhängigkeit vom Metallisierungsraster bei der Kontaktierung von Basis-, Emitter- und Kollektorgebieten erreicht. Bei der eingangs genannten integrierten Schaltung bildet die n-Wanne den Kollektor des Transistors und bedeckt n⁺-dotierte Zonen, die im Bipolartransistorbereich durch tiefreichende Kollektoranschlüsse angeschlossen werden. Dadurch werden die Vorteile der Silizid- bzw. Polyzid (= Doppelschicht aus Polysilizium und Metallsilizid) mit den Vorteilen eines tiefreichenden Kollektoranschlusses, wie Verringerung des Kollektorbahnwiderstandes und erhöhte Latch-up-Festigkeit, kombiniert.

Aus der europäischen Patentanmeldung EP-A-0 101 000 ist eine integrierte Halbleiterschaltung mit mindestens einem Bipolartransistor und mindestens einem MOS-Feldeffekttransistor auf einem Chip sowie ein Verfahren zu deren Herstellung bekannt, bei der die Kontakte aus der Metall-Leiterbahnebene zu den diffundierten aktiven Emitter- und Kollektorbereichen des Bipolartransistors sowie die Gateelektrode des MOS-Transistors aus einem undotierten Silizid eines hochschmelzenden Metalles bestehen. Durch die Verwendung des Silizids wird eine Unabhängigkeit vom Metallisierungsraster und eine Niederohmigkeit der Verdrahtung erreicht.

Aus der nachveröffentlichten, älteren europäischen Patentanmeldung EP-A-0 215 583, die zum Stand der Technik gemäß Artikel 54(3) EPü gehört, ist eine integrierte Halbleiterschaltung bekannt, die Bipolar- und MOS-Transistoren auf einem Substrat umfaßt, sowie ein Verfahren zu deren Herstellung. Dabei sind Basiskontakte, die Emitterkontakte, Kollektorkontakte, Sourcekontakte, Gatekontakte und Drainkontakte in einer Ebene aus Polysilizium angeordnet. Zur Verbesserung der Leitfähigkeit wird an der Oberfläche des Polysiliziums ein undotiertes Silizid gebildet. Die Flanken der Kontakte werden mit Flankenbedeckungen aus Oxid versehen.

Die Aufgabe, die der Erfindung zugrundeliegt, besteht in der Angabe eines Verfahrens zur Herstellung einer integrierte CMOS-Transistoren und Bipolartransistoren auf einem Chip enthaltenden Schaltung, bei der durch die Verwendung von Polyzid und Silizid als Diffusionsquelle und als Anschluß für den Emitter kleinere Emitterweiten möglich sind und damit eine weitere Erhöhung der Packungsdichte erreicht werden kann.

Weiterhin ist es Aufgabe der Erfindung, ein Verfahren anzugeben, welches die Herstellung dieser integrierten Schaltung in möglichst einfachen, maskensparenden Prozeßschritten erlaubt, wobei n- und p-Kanal-MOS-Transistoren mit entsprechend n⁺ oder p⁺-dotierten Polysilizium-Gates hergestellt werden können, wodurch die Kurzkanaleigenschaften infolge veränderter Dotierungsverhältnisse verbessert werden. Ein Verfahren dieser Art für p- und n-Kanal-MOS-Transistoren mit aus einer dotierten Doppelschicht aus Polysilizium und Metallsilizid bestehenden Gateelektroden ist in der nachveröffentlichten deutschen Patentanmeldung DE-A-3 541 940 bereits vorgeschlagen worden.

Die Aufgabe wird erfindungsgemäß gelöst durch ein Verfahren nach Anspruch 1. Es liegt im Rahmen der Erfindung, daß die Emitter- und Basisanschlüsse, sowie die Gateelektroden Flankenisolationsschichten (sogenannte spacer oxide) aufweisen.

Weitere Ausgestaltungen der Erfindung, insbesondere ein Verfahren, bei dem die Gatestrukturierung mittels lokaler Oxidation von Polysilizium und anschließender Oxidätzung durchgeführt wird, so daß an den Gates ein Oxidspacer entsteht und im Bereich der Bipolartransistoren der kritische Ätzvorgang von Polysilizium auf Silizium zur Trennung von Basis- und Emitteranschluß entfällt, ergeben sich aus den Unteransprüchen.

Gegenüber dem in der deutschen Patentanmeldung DE-A-35 32 817 vorgeschlagenen Verfahren weist das erfindungsgemäße Verfahren vor allem den Vorteil auf, daß Basis- und Emitteranschluß in der gleichen Ebene liegen und deshalb der Abstand Emitter- zu Basisanschluß noch weiter verringert wird und dadurch Bahnwiderstände verkleinert werden.

Im folgenden wird anhand der Figuren 1 bis 17 und zweier Ausführungsbeispiele der Prozeßablauf noch näher beschrieben. Dabei sind in den Figuren 1 bis 12 und in den Figuren 13 und 14 im Schnittbild die für die beiden Ausführungsbeispiele notwendigen Verfahrensschritte zusammengefaßt dargestellt, wobei für gleiche Teile die gleichen Bezugszeichen verwendet worden sind. Die Figuren 15 bis 17 zeigen den relativen Größenvergleich des Basis-Emitter-Komplexes eines npn-Transistors, hergestellt nach einem bekannten Verfahren (Figur 15), nach dem in der deutschen Patentanmeldung DE-A-35 32 817 beschriebenen Verfahren (Figur 16) und nach dem erfindungsgemäßen Verfahren (Figur 17).

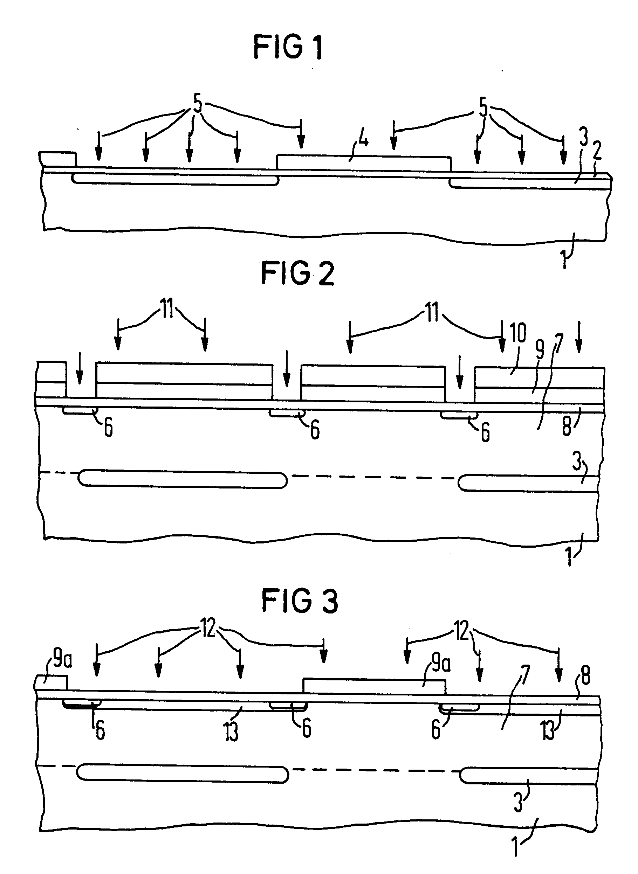

Figur 1: Auf einer einkristallinen, p-dotierten, (100)-orientierten Siliziumscheibe 1 mit einem spezifischen Widerstand von 20 Ohm cm und einer SiO₂-Schicht wird zunächst der vergrabene Kollektorbereich 3 dadurch erzeugt, daß nach erfolgter Photolackmaskierung 4 eine Antimon- oder Arsen-Ionenimplantation 5 mit einer Dosis und Energie von 3 x 10¹⁵ cm⁻² und 80 keV durchgeführt wird.

Figur 2: Die Bereiche für den tiefen Kollektoranschluß 6 werden dadurch hergestellt, daß auf die in Figur 1 dargestellte Anordnung nach Entfernung der SiO₂-Schicht 2 eine 3 µm-dicke p⁻-dotierte Epitaxieschicht 7 mit einem spezifischen elektrischen Widerstand von 20 Ohm cm abgeschieden wird und die Epitaxieschicht 7 mit einer isolierenden Doppelschicht, bestehend aus einer 50 nm dicken SiO₂-Schicht 8 und einer 140 nm dicken CVD-Siliziumnitridschicht 9 bedeckt wird. Durch die Photolacktechnik 10 wird die Nitridschicht 9 strukturiert und anschließend die Kollektortiefimplantation 11 mit Phosphor-Ionen bei einer Dosis und Energie von 3 x 10¹⁵ cm⁻² und 80 keV durchgeführt.

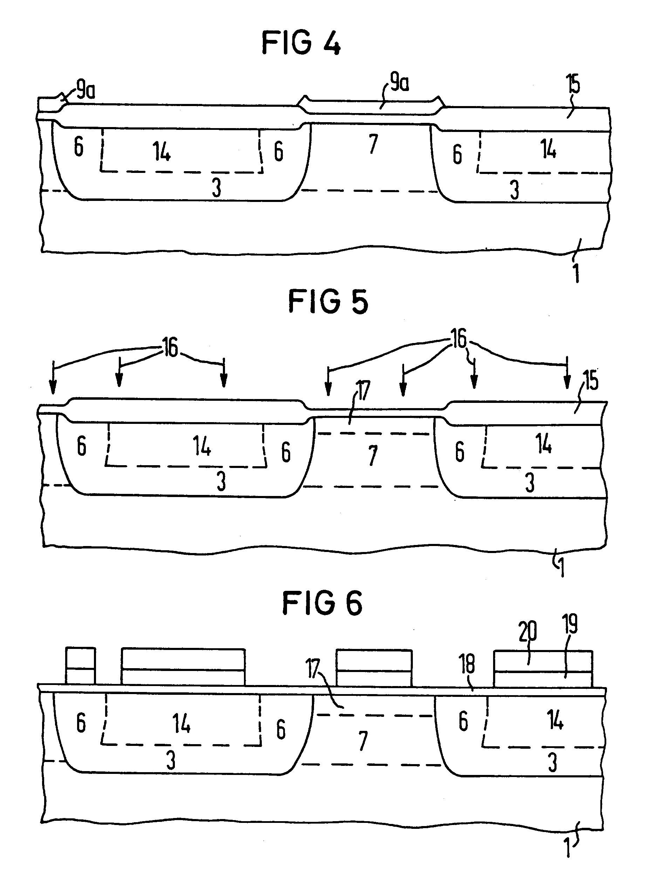

Figur 3 zeigt die Erzeugung der n-Wannenbereiche (14 in Figur 4) durch eine Phosphor-Ionenimplantation 12 mit einer Dosis und Energie von 2 x 10¹² cm⁻² und 180 keV nach erfolgter Photolacktechnik (nicht dargestellt) und Entfernung der Nitridstrukturen über den n-Wannenbereichen (14). Es bleibt die Nitridstrukturierung 9a und es entstehen die implantierten Bereiche 13.

Figur 4: Nun erfolgt die Oxidation zur Maskierung der n-Wannenbereiche (14) und gleichzeitig die Eindiffusion der Phosphor-Ionen, das heißt der drive-in von n-Wanne 14 und Kollektoranschluß 6. Auf der Oberfläche entsteht eine SiO₂-Schicht 15, wobei die Nitridmaske 9a als Maskierung dient. Bei dieser Temperaturbehandlung (1150°C) wird der Kollektoranschluß 6 ca. 3 µm in das Substrat 1 eingetrieben, so daß der vergrabene Kollektorbereich 3 sicher erreicht wird.

Figur 5: Die erste tiefe Implantation der Doppel-Kanalimplantation der n-Kanal-Transistoren erfolgt nach Entfernung der Siliziumnitridstruktur 9a durch ganzflächige Tiefimplantation 16 mit Bor-Ionen bei einer Dosis und Energie von 8 x 10¹¹ cm⁻² und 60 keV, wobei die SiO₂-Schicht 15 als Maske wirkt. Es entsteht der p-dotierte Bereich 17 unter dem Kanal.

Figur 6: Es folgt die Erzeugung einer aus thermischem SiO₂ (50 nm) und abgeschiedenem Siliziumnitrid (140 nm) bestehenden Doppelschicht 18, 19 und entsprechende Strukturierung der Siliziumnitridschicht 19 mit der Photolacktechnik 20 als Maskierung für die später nachfolgende lokale Oxidation (LOCOS).

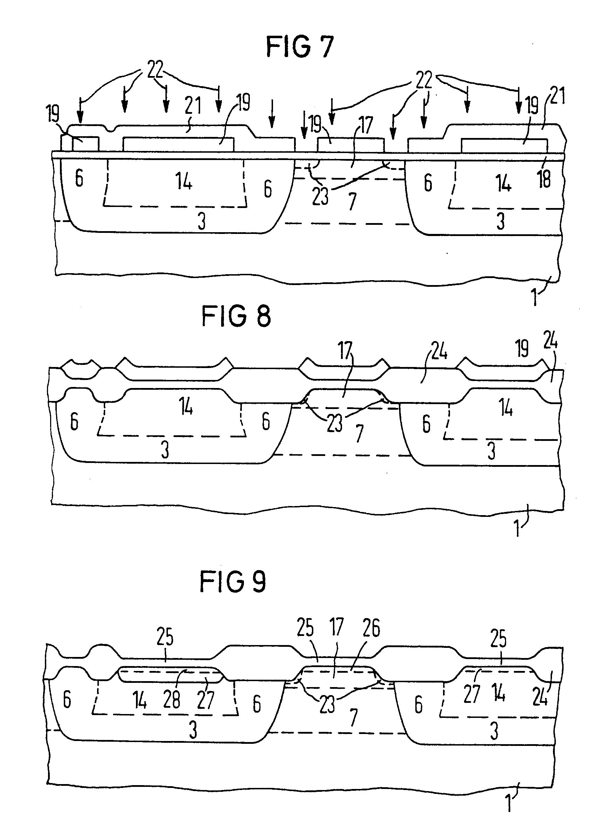

Figur 7: Zur Erzeugung der Felddotierung im n-Kanalbereich wird nach erneuter Photolacktechnik 21 eine Bor-Ionenimplantation 22 mit einer Dosis und Energie von 1,2 x 10¹³ cm⁻² und 25 keV durchgeführt. Es entstehen die p-dotierten Bereiche 23.

Figur 8: Nun wird das für die Trennung der aktiven Transistorbereiche im Substrat 1 erforderliche Feldoxid 24 durch lokale Oxidation unter Verwendung der Siliziumnitridmaskierung 19 nach Entfernung der Photolackmaske 21 auf der SiO₂-Schicht 18 in einer Schichtdicke von 850 nm erzeugt. Die beiden Oxidschichten werden ab jetzt mit dem Bezugszeichen 24 bezeichnet.

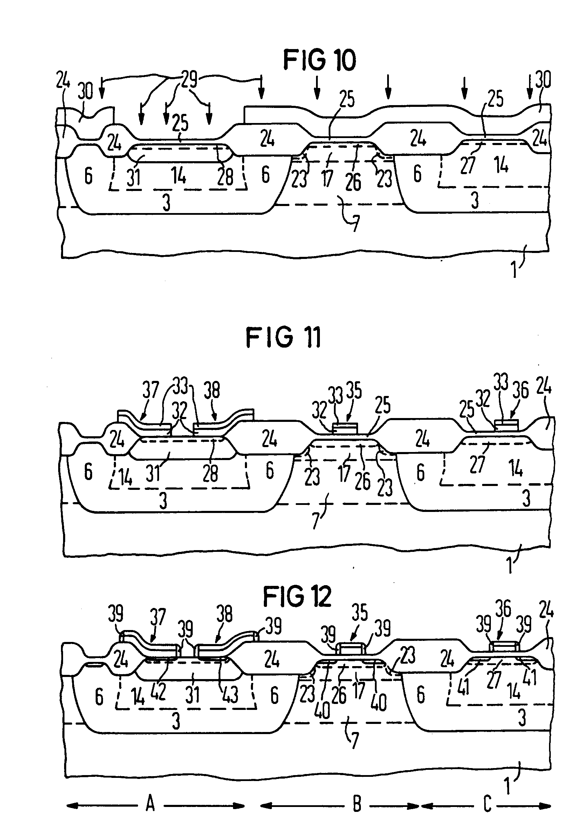

Figur 9: Nach Entfernung der Siliziumnitridstrukturen 19 erfolgt nun die Gateoxidation mit einer Schichtdicke des Gateoxids 25 von 25 nm. Wenn als Emitteranschluß- und Gatematerial Polyzid verwendet werden soll, empfiehlt es sich, an dieser Stelle wegen der erhöhten Kanaldotierung eine tiefe und eine flache Kanalimplantation mit Bor-Ionen durchzuführen (nicht dargestellt), wobei die flache Implantation ganzflächig mit einer Dosis und Energie von 2 x 10¹¹ cm⁻² und 25 keV und die tiefe Implantation mit Phototechnik nur im n-Kanalbereich der MOS-Transistoren mit einer Dosis und Energie von 8 x 10¹¹ cm⁻² und 60 keV durchgeführt wird. Es entstehen die Kanalbereiche 26 und 27 und der p-Bereich 28 in der Basis des Bipolartransistors.

Figur 10: Nun erfolgt die Basisimplantation 29 des Bipolartransistors nach vorheriger Photolackmaskierung 30 mit Bor-Ionen mit einer Dosis und Energie von 9 x 10¹³ cm⁻² und 80 keV. Es entsteht die p-dotierte Basiszone 31. Im Bereich der Basiszone 28, 31 wird die Gateoxidschicht 25 entfernt. Bis hierher sind die Prozeßschritte identisch mit den in Figur 1 bis 10 dargestellten Prozeßschritten der nachveröffentlichten deutschen Patentanmeldung DE-A-35 19 790.

Figur 11: Die Gateelektroden der MOS-Transistoren B, C (35, 36) sowie der Basis- (37) und Emitteranschluß (38) des Bipolartransistors A werden dadurch erzeugt, daß nach Entfernung der Photolackstrukturen 30 eine ganzflächige Abscheidung einer Doppelschicht, bestehend aus einer Polysiliziumschicht 32 und einer Tantalsilizidschicht 33 durchgeführt wird und anschließend die Gateelektroden 35, 36 und die Basis- und Emitteranschlüsse 37, 38 mittels Photolacktechnik (in der Figur nicht dargestellt) strukturiert werden. Anstelle der Doppelschicht 32, 33 kann auch eine einfache Tantalsilizidschicht 33 verwendet werden.

Figur 12: Durch ganzflächige Oxidabscheidung, beispielsweise durch thermische Zersetzung von Tetraethylorthosilikat und einem Rückätzschritt werden nun die Flankenisolationsschichten 39 (sogenannte spacer) an den Gatestrukturen 35, 36, sowie den Emitter- und Basisanschlußstrukturen 37, 38 erzeugt. Dann erfolgt die Herstellung der Source/Drain-Bereiche 40 der n-Kanal-Transistoren B und gleichzeitig die n-Dotierung des Emitteranschlusses 38 des Bipolartransistors A und der Gateelektrode 35 durch Phosphor-Ionen-Implantation bei einer Dosis und Energie von 8 x 10¹⁵ cm⁻² und 80 keV nach vorheriger Photolackmaskierung der übrigen Bereiche (p-Kanal-Transistoren, Bipolartransistorbereich mit Ausnahme des Emitteranschlußbereiches 38). Dieser Vorgang ist im einzelnen nicht dargestellt.

In analoger Weise wie beschrieben werden die Source/Drain-Bereiche 41 der p-Kanal-Transistoren C und gleichzeitig die p-Dotierung des Basisanschlusses 37 des Bipolartransistors A und der Gateelektrode 36 durch Bor-Ionen-Implantation mit einer Dosis und Energie von 4 x 10¹⁵ cm⁻² und 40 keV erzeugt. Dabei werden die n-Kanal-Transistorbereiche B und der Emitteranschluß 38 des Bipolartransistors A mit einer Photolackmaske abgedeckt. Der Abstand Emitter-/Basis-Anschluß (37, 38) ist durch das spacer oxide 39 definiert.

Nach der Diffusion von Emitter- und Basisanschluß in die Zonen 42, 43 erfolgt die Fertigstellung der Schaltungsanordnung in bekannter Weise durch Kontaktlochtechnik, Metallisierung (Einlagen- oder Zweilagenmetallisierung) und Passivierung.

Die unter der Figur 12 eingezeichneten Buchstaben (A, B, C) markieren den Bereich des Bipolartransistors A und die Bereiche des n-Kanal-Transistors B sowie des p-Kanal-Transistors C.

In einer Version des erfindungsgemäßen Verfahrens ist es auch möglich, von einem p-dotierten Substrat (1) mit einem spezifischen elektrischen Widerstand von 0,02 Ohm cm auszugehen und die in Figur 1 dargestellte Implantation zur Erzeugung des vergrabenen Kollektors wegzulassen oder bei einem Ausgangsmaterial von 20 Ohm cm die in Figur 1 dargestellte Implantation wegzulassen und die in Figur 3 dargestellte Epitaxieschicht nicht aufzubringen. Durch die Einsparung des vergrabenen Kollektors ergibt sich eine Prozeßvereinfachung.

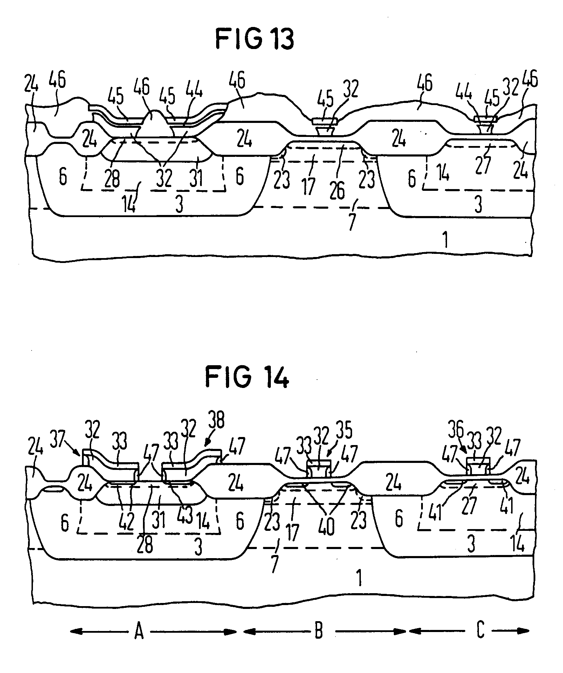

Abweichend von den in den Figuren 1 bis 12, insbesondere Figur 11 und 12 beschriebenen Ausführungsbeispiels ist auch eine andere Variante des erfindungsgemäßen Verfahrens möglich. Dabei wird anstelle der in Figur 11 beschriebenen Strukturierung der Doppelschicht (32, 33) zur Bildung des Emitter/Basisanschlusses (37, 38) und der Gateelektroden (35, 36) eine Polysiliziumschicht aufgebracht, lokal oxidiert und zur Erzeugung der spacer (47) eine anisotrope Oxidätzung durchgeführt. Dabei entsteht an den Gates ein oxide spacer und im Bereich des Bipolartransistors entfällt der kritische Ätzvorgang von Polysilizium auf dem einkristallinen Silizium zur Trennung von Basis- und Emitteranschluß. Wie im einzelnen vorgegangen wird, ist aus den Figuren 13 und 14 ersichtlich.

Figur 13: Es werden zunächst alle Prozeßschritte durchgeführt, wie sie bereits anhand der Figuren 1 bis 10 für das Ausführungsbeispiel 1 beschrieben worden sind. Dann wird ganzflächig eine Polysiliziumschicht 32 und eine Doppelschicht, bestehend aus SiO₂ 44 und Siliziumnitrid 45 aufgebracht und die Dreifachschicht (32, 44, 45) entsprechend der Gateelektroden 35, 36 und der Emitter- und Basisanschlüsse 37, 38 durch Phototechnik und Nitridätzung strukturiert. Durch Oxidation des Polysilizium entsteht die Oxidschicht 46.

Figur 14: Es erfolgt nun eine anisotrope Oxidätzung der SiO₂-Schicht 46 zur Erzeugung der spacer 47, die im Gegensatz zu den spacer 39 in Figur 12 eine invertierte Form aufweisen. Die Siliziumnitridmaske 45 wird entfernt und eine selektive Tantalsilizidabscheidung 33 auf den Gates 35, 36 und den Emitter- 38 und Basisanschlüssen 37 durchgeführt. Alle weiteren Prozeßschritte erfolgen wie bei Figur 12 beschrieben. Es gelten hierfür die gleichen Bezugszeichen.

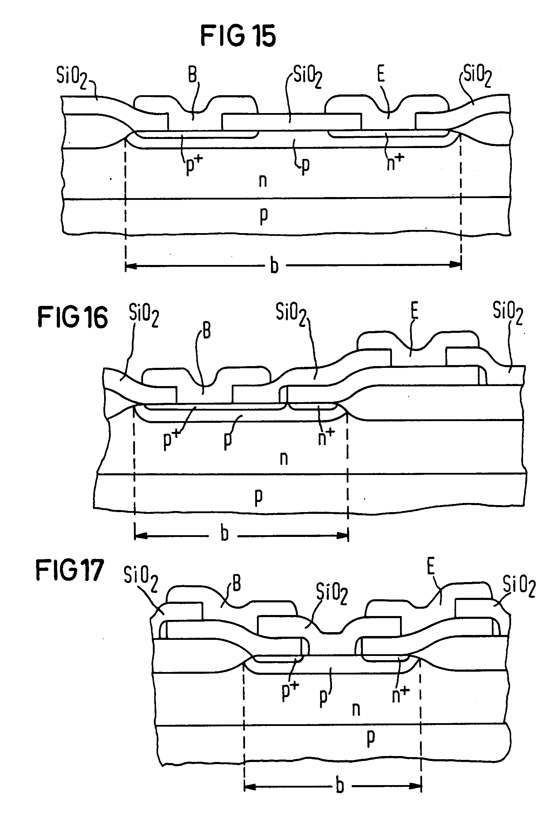

Aus den Figuren 15 bis 17 ist ein relativer Größenvergleich des Basis (B)-Emitter (E)-Komplexes eines herkömmlichen npn-Transistors (Figur 15) ohne Selbstjustierung, eines nach dem Verfahren nach der deutschen Patentanmeldung DE-A-35 32 817 mit Emitter-Basis-Selbstjustierung, aber in zwei Ebenen liegenden Anschlüssen (Figur 16) und eines nach dem erfindungsgemäßen Verfahren hergestellten Bipolartransistors (17) ersichtlich. Mit den Buchstaben "b" ist die minimale Basisbreite eingezeichnet. Ansonsten wurden die Dotierungen eingezeichnet. Mit dem Symbol "SiO₂" ist das Isolationsoxid versehen. Die Buchstaben "B" und "E" bedeuten Basis und Emitter.

## Patentansprüche

1. Verfahren zum Herstellen einer mindestens einen Bipolartransistor (A), einen n-Kanal-MOS-Transistor (B) und einen dazu komplementären p-Kanal-MOS-Transistor (C) auf einem gemeinsamen Substrat enthaltenden Schaltung, bei der Emitter- und Basisanschlüsse der Bipolartransistoren, sowie die Gateelektroden der MOS-Transistoren mindestens teilweise aus einem dotierten Silizid eines hochschmelzenden Metalles bestehen, mit folgenden Schritten:
a) auf der Oberfläche des Substrats (1) wird ganzflächig eine mindestens ein Silizid eines hochschmelzenden Metalles enthaltende Schicht (33) aufgebracht,
b) nach entsprechender Maskierung wird die Schicht (33) so strukturiert, daß daraus ein Basisanschluß (37) und ein Emitteranschluß (38) für den Bipolartransistor (A), eine Gateelektrode (35) für den n-Kanal-MOS-Transistor (B) und eine Gateelektrode (36) für den p-Kanal-MOS-Transistor (C) gebildet werden,
c) nach einer weiteren Maskierung, die die Source- und Drain-Gebiete (41) sowie die Gateelektrode (36) des p-Kanal-Transistors und den Basisanschluß (37) des Bipolartransistors abdeckt, erfolgt eine Ionenimplantation und Diffusion mit n-dotiertenden Ionen, bei der die Source- und Drain-Gebiete (40) sowie die Gateelektrode (35) für den n-Kanal-Transistor und der Emitteranschluß (38) für den Bipolartransistor n-dotiert werden,
d) nach einer weiteren Maskierung, die die Source- und Drain-Gebiete (40) sowie die Gateelektrode (35) des n-Kanal-MOS-Transistors und den Emitteranschluß (38) des Bipolartransistors abdeckt, erfolgt eine Ionenimplantation und Diffusion mit p-dotierenden Ionen, bei der die Source- und Drain-Gebiete (41) sowie die Gateelektrode (36) des p-Kanal-MOS-Transistors und der Basisanschluß (37) des Bipolartransistors p-dotiert werden.

2. Verfahren nach Anspruch 1,
**dadurch gekennzeichnet,**
daß die Basis- und Emitteranschlüsse (37, 38), sowie die Gateelektroden (35, 36) aus einer Doppelschicht (32, 33) aus Polysilizium und Tantalsilizid gebildet werden.

3. Verfahren nach Anspruch 1 oder 2,
**dadurch gekennzeichnet,**
daß die Basis- und Emitteranschlüsse (37, 38) sowie die Gateelektroden (35, 36) mit Flankenisolationsschichten (39, 47) (= sogenannte spacer oxide) versehen werden.

4. Verfahren nach einem der Ansprüche 1 bis 3,
**gekennzeichnet durch** den Ablauf der folgenden Verfahrensschritte:
a) Erzeugung einer ganzflächigen Isolations-Doppelschicht aus Siliziumoxid (8) und Siliziumnitrid (9) an der Oberfläche eines p-dotierten Substrates (1),
b) Festlegung der Bereiche für den tiefereichenden Kollektoranschluß (6) durch eine Tiefimplantation (11) mit n-dotierenden Ionen nach vorheriger Strukturierung der Siliziumnitridschicht (9) durch Photolithographie (10),
c) Erzeugen der n-Wannen (14) im Substrat (1) durch Implantation (12) von n-dotierenden Ionen nach Ablösen der Siliziumnitridstrukturen über den n-Wannenbereichen (14),
d) Eindiffusion der implantierten, n-dotierenden Ionen in das Substrat (1) und gleichzeitige Oxidation (15) der Oberfläche in den n-Wannenbereichen (14),
e) Durchführung einer Tiefimplantation (16) von Bor-Ionen zur Herstellung eines oberflächenfernen Bereiches der Kanalzone (17) der n-Transistoren (B) nach Entfernung der Siliziumnitridstrukturen, wobei das Oxid (15) als Maske wirkt,
f) Aufbringen einer aus Siliziumoxid (18) und Siliziumnitrid (19) bestehenden Doppelschicht und entsprechende Strukturierung der Siliziumnitridschicht (19) für die nachfolgende lokale Oxidation (LOCOS),
g) Durchführung einer Bor-Ionen-Implantation (22) zur Dotierung der Feldoxidbereiche (23) der n-Kanal-Transistoren nach vorheriger Photolackmaskierung (21) der übrigen Bereiche,
h) Herstellung des für die Trennung der aktiven Transistorbereiche (A, B, C) im Substrat (1) erforderlichen Feldoxids (24) durch lokale Oxidation nach Entfernung der Photolackmaske (21) und unter Verwendung der Siliziumnitrid-Struktur (19) als Oxidationsmaske,
i) ganzflächige Oxidation zur Erzeugung des Gateoxids (25) nach Entfernung der Siliziumnitridstrukturen (19),
j) Durchführung einer ganzflächigen, flachen Bor-Ionen-Implantation zur Dotierung der Kanalbereiche (26, 27) der n- und p-Kanal-MOS-Transistoren,
k) Herstellung der Basiszone (31) im Bipolar-Transistorbereich (A) durch Bor-Ionen-Implantation (29) nach vorheriger Photolackmaskierung (30) der übrigen Bereiche,
l) Entfernung des Gateoxids (25) im Bereich der Basiszone (31),
m) ganzflächige Abscheidung von Metallsilizid (33) oder einer Doppelschicht aus Polysilizium (32) und Metallsilizid (33),
n) Strukturierung der Metallsilizidschicht (33) oder der Polyzid-Doppelschicht (32, 33) zur Herstellung der Gateelektroden (35, 36) der MOS-Transistoren (B, C), sowie der Basis- und Emitteranschlüsse (37, 38) der Bipolartransistoren (A),
o) Erzeugung einer Flankenisolationsschicht (39) (= spacer oxide) durch ganzflächige Oxidabscheidung aus der Gasphase und Rückätzen,
p) gleichzeitige Herstellung der Source/Drain-Bereiche (40) der n-Kanal-Transistoren (B), der n-Dotierung des Kollektor- und Emitteranschlusses (38) der Bipolartransistoren (A) und der Gateelektrode (35) der n-Kanal-Transistoren (B) durch Phosphor-Ionen-Implantation nach vorheriger Photolackmaskierung der p-Kanal-Transistorbereiche (C) und der Bipolar-Transistorbereiche (A) mit Ausnahme des n-Emitterbereiches (38) und des Kollektoranschlußbereiches,
q) gleichzeitige Herstellung der Source/Drain-Bereiche (42) der p-Kanal-Transistoren (C), der p-Dotierung des Basiskontaktes (37) der Bipolar-Transistoren (A) und der Gateelektrode (36) der p-Kanal-Transistoren (C) durch Bor-Ionen-Implantation nach vorheriger Photolackmaskierung (44) der n-Kanal-Transistorbereiche (B) und der Bipolar-Transistorbereiche (A) mit Ausnahme des p-Basisbereiches (37),
r) Durchführung einer Hochtemperaturbehandlung zur Diffusion der Basis- und Emitteranschlüsse (37, 38),
s) Abscheidung einer ganzflächigen, als Zwischenoxid wirkenden Siliziumoxidschicht aus der Gasphase,
t) Freilegung der Kontaktlochbereiche, Durchführung der Metallisierung zur Herstellung der Anschlußelektroden und Passivierung in bekannter Weise.

5. Verfahren nach Anspruch 4,
**dadurch gekennzeichnet,**
daß vor der Erzeugung der ganzflächigen Isolationsdoppel-Schicht (8, 9) in dem Substrat (1) eine vergrabene n⁺-dotierte Zone (3) durch Implantation von n-dotierenden Ionen nach vorheriger Maskierung (4) der übrigen Bereiche hergestellt wird und daß eine p-dotierte Epitaxieschicht (7) aufgebracht wird.

6. Verfahren nach Anspruch 4 oder 5,
**dadurch gekennzeichnet,**
daß anstelle der Verfahrensschritte m), n) und o) folgende Verfahrensschritte durchgeführt werden:
m₁) Abscheidung der Schichtenfolge Polysilizium (32), SiO₂ (44) und Siliziumnitrid (45),
n₁) Strukturierung der Siliziumnitridschicht (45) zur Herstellung der Gate-Elektroden (35, 36) und der Basis- und Emitteranschlüsse (37, 38) und Aufoxidation der Polysiliziumschicht (32) unter Verwendung der Nitridstruktur (45) als Maskierung,
o₁) Durchführung einer anisotropen Oxidätzung zur Erzeugung der spacer oxide (47) und selektive Silizid-Abscheidung (33) auf den Gateelektroden (35, 36) und den Basis- und Emitteranschlüssen (37, 38).

7. Verfahren nach einem der Ansprüche 4 bis 6,
**dadurch gekennzeichnet,**
daß zwischen Verfahrensschritt i) und j) nach vorheriger Phototechnik eine BorIonenimplantation im Bereich der n-Kanal-MOS-Transistoren (B) durchgeführt wird.

8. Verfahren nach Anspruch 4 bis 7,
**dadurch gekennzeichnet,**
daß ein p-dotiertes (100)-orientiertes Siliziumsubstrat (1) mit einem spezifischen elektrischen Widerstand von 20 Ohm cm verwendet wird.

9. Verfahren nach Anspruch 4 und 7,
**dadurch gekennzeichnet,**
daß ein p-dotiertes, (100)-orientiertes Siliziumsubstrat (1) mit einem spezifischen elektrischen Widerstand von 0,02 Ohm cm verwendet wird.

10. Verfahren nach mindestens einem der Ansprüche 5 bis 9,
**dadurch gekennzeichnet,**
daß der spezifische elektrische Widerstand der p-dotierten Epitaxieschicht (7) auf 20 Ohm cm und die Schichtdicke auf ca. 3 µm eingestellt wird.

11. Verfahren nach mindestens einem der Ansprüche 4 bis 10,
**dadurch gekennzeichnet,**
daß die Herstellung der Flankenisolationsschicht (39, 47) nach Verfahrensschritt o) durch thermische Zersetzung von Tetraethylorthosilikat (= TEOS) erfolgt.

## Claims

1. Method of producing a circuit which contains at least one bipolar transistor (A), an n-channel MOS transistor (B) and a p-channel MOS transistor (C), complementary thereto, on a common substrate and in which emitter and base connections of the bipolar transistors, and also the gate electrodes of the MOS transistors comprise, at least partly, a doped silicide of a refractory metal, which method comprises the following steps:
a) a layer (33) containing at least one silicide of a refractory metal is applied over the entire surface to the surface of the substrate (1),
b) after suitable masking, the layer (33) is patterned in such a way that a base connection (37) and an emitter connection (38) for the bipolar transistor (A), a gate electrode (35) for the n-channel MOS transistor (B) and a gate electrode (36) for the p-channel MOS transistor (C) are formed therefrom,
c) after a further masking, which covers the source and drain regions (41) and the gate electrode (36) of the p-channel transistor and the base connection (37) of the bipolar transistor, an ion implantation and diffusion using n-doping ions, in which the source and drain regions (40), and the gate electrode (35) for the n-channel transistor and the emitter connection (38) for the bipolar transistor are n-doped, are carried out,
d) after a further masking, which covers the source and drain regions (40), and the gate electrode (35) of the n-channel MOS transistor and the emitter connection (38) of the bipolar transistor, an ion implantation and diffusion using p-doping ions, in which the source and drain regions (41) and the gate electrode (36) of the p-channel-MOS transistor and the base connection (37) of the bipolar transistor are p-doped, are carried out.

2. Method according to Claim 1, characterised in that the base and emitter connections (37, 38), and the gate electrodes (35, 36) are formed from a double layer (32, 33) of polysilicon and tantalum silicide.

3. Method according to Claim 1 or 2, characterised in that the base and emitter connections (37, 38) and the gate electrodes (35, 36) are provided with edge insulation layers (39, 47) (= so-called spacer oxide).

4. Method according to one of Claims 1 to 3, characterised by the completion of the following method steps:
a) Production, over the entire surface, of an insulating double layer composed of silicon oxide (8) and silicon nitride (9) at the surface of a p-doped substrate (1),
b) Definition of the regions for the deep-reaching collector connection (6) by a deep implantation (11) using n-doping ions after prior patterning of the silicon nitride layer (9) by photolithography (10),
c) Production of the n-type wells (14) in the substrate (1) by implantation (12) of n-doping ions after stripping the silicon nitride structures of the n-type well regions (14),
d) Drive-in of implanted, n-doping ions into the substrate (1) and simultaneous oxidation (15) of the surface in the n-type well regions (14),
e) Performance of a deep implantation (16) of boron ions to produce a region (remote from the surface) of the channel zone (17) of the n-channel transistors (B) after removal of the silicon nitride structures, the oxide (15) acting as a mask,
f) Application of a double layer comprising silicon oxide (18) and silicon nitride (19) and suitable patterning of the silicon nitride layer (19) for the subsequent local oxidation (LOCOS),
g) Performance of a boron-ion implantation (22) in order to dope the field-oxide regions (23) of the n-channel transistors after prior photoresist masking (21) of the remaining areas,
h) Production of the field oxide (24), necessary for the isolation of the active transistor regions (A, B, C) in the substrate (1), by local oxidation after removing the photoresist mask (21), the silicon nitride structure (19) being used as oxidation mask,
i) Oxidation over the entire surface in order to produce the gate oxide (25) after removing the silicon nitride structures (19),
j) Performance of a shallow boron ion implantation over the entire surface in order to dope the channel regions (26, 27) of the n- and p-channel MOS transistors,
k) Production of the base zone (31) in the bipolar transistor region (A) by boron-ion implantation (29) after prior photoresist masking (30) of the other regions,
l) Removal of the gate oxide (25) in the region of the base zone (31),
m) Deposition, over the entire surface, of metal silicide (33) or of a double layer composed of polysilicon (32) and metal silicide (33),
n) Patterning of the metal silicide layer (33) or of the polycide double layer (32, 33) in order to produce the gate electrodes (35, 36) of the MOS transistors (B, C), and also of the base and emitter connections (37, 38) of the bipolar transistors (A),
o) Production of an edge insulating layer (39) (= spacer oxide) by oxide deposition over the entire surface from the gas phase and back-etching,
p) Simultaneous production of the source/drain regions (40) of the n-channel transistors (B), the n-doping of the collector and emitter connection (38) of the bipolar transistors (A) and of the gate electrode (35) of the n-channel transistors (B) by phosphorusion implantation after prior photoresist masking of the p-channel transistor regions (C) and of the bipolar transistor regions (A) with the exception of the n-type emitter region (38) and of the collector connection region,
q) Simultaneous production of the source/drain regions (42) of the p-channel transistors (C), the p-doping of the base contact (37) of the bipolar transistors (A) and of the gate electrode (36) of the p-channel transistors (C) by boron-ion implantation of the prior photoresist masking (44) of the n-channel transistor regions (B) and of the bipolar transistor regions (A) with the exception of the p-type base region (37),
r) Performance of high-temperature treatment to diffuse the base and emitter connections (37, 38),
s) Deposition, over the entire surface, of a silicon oxide layer, which acts as intermediate oxide, from the gas phase, and
t) Uncovering of the contact via regions, performance of the metallisation to produce the connection electrodes and passivation in a known manner.

5. Method according to Claim 4, characterised in that, prior to the production of the insulating double layer (8, 9) in the substrate (1) over the entire surface, a buried n⁺-doped zone (3) is produced by implantation of n-doping ions after prior masking (4) of the other regions, and in that a p-doped epitaxial layer (7) is applied.

6. Method according to Claim 4 or 5, characterised in that, instead of the method steps m), n) and o), the following method steps are carried out:
m₁) Deposition of the layer sequence comprising polysilicon (32), SiO₂ (44) and silicon nitride (45),
n₁) Patterning of the silicon nitride layer (45) in order to produce the gate electrodes (35, 36) and the base and emitter connections (37, 38) and oxidation of the polysilicon layer (32) using the nitride structure (45) as masking,
o₁) Performance of an anisotropic oxide etching in order to produce the spacer oxides (47) and selective silicide deposition (33) on the gate electrodes (35, 36) and the base and emitter connections (37, 38).

7. Method according to one of Claims 4 to 6, characterised in that, between method step i) and j), a boron-ion implantation is performed, after a prior photolithography procedure, in the region of the n-channel MOS transistors (B).

8. Method according to Claims 4 to 7, characterised in that a p-doped (100)-oriented silicon substrate (1) having an electrical resistivity of 20 ohm · cm is used.

9. Method according to Claims 4 and 7, characterised in that a p-doped (100)-oriented silicon substrate (1) having an electrical resistivity of 0.02 ohm · cm is used.

10. Method according to at least one of Claims 5 to 9, characterised in that the electrical resistivity of the p-doped epitaxial layer (7) is adjusted to 20 ohm · cm and the layer thickness to approximately 3 µm.

11. Method according to at least one of Claims 4 to 10, characterised in that the production of the edge insulating layer (39, 47) in accordance with method step o) is performed by thermal decomposition of tetraethyl orthosilicate (= TEOS).

## Revendications

1. Procédé de fabrication d'un circuit qui comporte, sur un substrat commun, au moins un transistor bipolaire (A), un transistor MOS à canal n (B) et un transistor MOS à canal p (C) complémentaire au précédent, circuit dans lequel les bornes d'émetteur et de base des transistors bipolaires, ainsi que les électrodes de grille des transistors MOS sont constituées au moins en partie d'un siliciure dopé d'un métal à point de fusion élevé, et dans lequel procédé les phases opératoires suivantes sont mises en oeuvre :
a) sur la surface du substrat (1), on dépose en pleine surface une couche composée d'au moins un siliciure d'un métal à point de fusion élevé,
b) après masquage correspondant, on structure la couche (33) de telle sorte qu'à partir de cette couche, sont formées une borne de base (37) et une borne d'émetteur (38) pour le transistor bipolaire (A), une électrode de grille (35) pour le transistor MOS à canal n (B), et une électrode de grille (36) pour le transistor MOS à canal p (C),
c) après un second masquage, qui recouvre les zones de source et de drain (41) ainsi que l'électrode de grille (36) du transistor à canal p et la borne de base (37) du transistor bipolaire, on procède à une implantation d'ions et à une diffusion à ions dopants n, au cours de laquelle sont dopées n les zones de source et de drain (40) ainsi que l'électrode de grille (35) du transistor à canal n et la borne d'émetteur (38) du transistor bipolaire,
d) après un troisième masquage, qui recouvre les zones de source et de drain (40) ainsi que l'électrode de grille (35) du transistor MOS à canal n et la borne d'émetteur (38) du transistor bipolaire, on effectue une implantation d'ions et une diffusion à ions dopants p, au cours de laquelle sont dopées p les zones de source et de drain (41) ainsi que l'électrode de grille (36) du transistor MOS à canal p et la borne de base (37) du transistor bipolaire.

2. Procédé suivant la revendication 1,
caractérisé en ce que les bornes de base et d'émetteur (37,38) ainsi que les électrodes de grille (35,36) sont formées à partir d'une couche double (32,33) de polysilicium et de siliciure de tantale.

3. Procédé suivant la revendication 1 ou 2,
caractérisé en ce que les bornes de base et d'émetteur (37,38) ainsi que les électrodes de grille (35,36) sont munies de couches isolantes de leurs flancs (39,47), (désignées par spacer oxide).

4. Procédé suivant l'une des revendications 1 à 3,
caractérisé par le déroulement des phases opératoires suivantes :
a) production, sur la surface d'un substrat (1) dopé p, d'une couche double isolante en pleine surface, composée d'oxyde de silicium (8) et de nitrure de silicium (9),
b) fixation des zones pour le contact de collecteur (6) s'étendant profondément, par une implantation profonde (11) d'ions dopants n après structuration antérieure de la couche (9) de nitrure de silicium, par photolithographie (10),
c) production des cuvettes n (14) dans le substrat (1), par implantation (12) d'ions dopants n, après suppression des structures en nitrure de silicium, sur les zones n en cuvette (14),
d) diffusion en profondeur, dans le substrat (1), d'ions dopants n implantés, et, oxydation simultanée (15) de la surface, dans les zones n en cuvette (14),
e) exécution d'une implantation profonde (16) d'ions bore, pour la réalisation d'une zone de canal (17) des transistors n (B) distante de la surface, après suppression des structures en nitrure de silicium, l'oxyde (15) agissant comme masque,
f) dépôt d'une couche double constituée d'oxyde de silicium (18) et de nitrure de silicium (19) et structuration correspondante de la couche de nitrure de silicium (19) pour la post-oxydation locale (LOCOS),
g) exécution d'une implantation (22) d'ions bore pour le dopage des zones d'oxyde de champ (23) des transistors à canal n, après masquage antérieur (21) en technique photorésist des autres zones,
h) réalisation de l'oxyde de champ (24) nécessaire à la séparation des zones actives des transistors (A, B, C), dans le substrat (1), par oxydation locale après suppression du masque de photorésist (21) et avec utilisation de la structure (19) en nitrure de silicium comme masque d'oxydation,
i) oxydation en pleine surface pour la production de l'oxyde de grille (25), après suppression des structures (19) en nitrure de silicium,
j) exécution d'une implantation plane et en pleine surface d'ions bore pour le dopage des zones de canal (26, 27) des transistors MOS à canal n et p,
k) réalisation de la zone de base (31) dans la région (A) du transistor bipolaire, par implantation d'ions bore (29), après masquage antérieur (30) en technique photorésist des autres zones,
l) suppression de l'oxyde de grille (25) dans la région de la zone de base (31),
m) dépôt en pleine surface du siliciure métallique (33) ou d'une couche double de polysilicium (32) et de siliciure métallique (33),
n) structuration de la couche de siliciure métallique (33) ou de la couche double de polysiliciure (32, 33), pour la réalisation des électrodes de grille (35, 36) des transistors MOS (B, C), ainsi que des bornes de base et d'émetteur (37, 38) des transistors bipolaires (A),
o) production d'une couche isolante de flancs (39) (= spacer oxide), par dépôt en pleine surface d'oxyde en phase gazeuse et par rétro corrosion,
p) réalisation simultanée des zones source-drain (40) des transistors à canal n (B), du dopage n des bornes de collecteur et d'émetteur (38) des transistors bipolaires (A) et de l'électrode de grille (35) des transistors à canal n (B), par implantation d'ions phosphore, après masquage antérieur en technique photorésist des zones de transistors à canal p (C) et des zones de transistors bipolaires (A), à l'exception de la zone d'émetteur n (38) et de la zone de contact de collecteur,
q) réalisation simultanée des zones source-drain (42) des transistors à canal p (C), du dopage p du contact de base (37) des transistors bipolaires (A) et de l'électrode de grille (36) des transistors à canal p (C), par implantation d'ions bore, après masquage antérieur (44) en technique photorésist des zones de transistors à canal n (B) et des zones de transistors bipolaires (A) à l'exception de la zone de base p (37),
r) exécution d'un traitement à haute température pour la diffusion des bornes de base et d'émetteur (37, 38),
s) dépôt, en pleine surface, d'une couche d'oxyde de silicium en phase gazeuse, agissant comme oxyde intermédiaire,
t) dégagement des zones destinées à la réalisation des trous de contact, exécution de la métallisation pour la réalisation des électrodes de contact et passivation d'une manière connue.

5. Procédé suivant la revendication 4,
caractérisé en ce que, avant la production de la couche double isolante (8, 9) en pleine surface, une zone ensevelie dopée n⁺ (3) est réalisée dans le substrat (1), par implantation d'ions dopants n, après masquage antérieur (4) des autres zones, et qu'une couche épitaxiale dopée p (7) est déposée.

6. Procédé suivant la revendication 4 ou 5,
caractérisé en ce que, à la place des phases opératoires m), n) et o), on effectue les phases opératoires suivantes :
m₁) dépôt de la succession de couches de polysilicium (32), de SiO₂ (44) et de nitrure de silicium (45),
n₁) structuration de la couche de nitrure de silicium (45) pour la réalisation des électrodes de grille (35,36) et des bornes de base et d'émetteur (37,38) et oxydation de la couche de polysilicium (32) avec utilisation de la structure en nitrure (45) comme masquage,
o₁) exécution d'une attaque d'oxyde anisotrope pour la production du "spacer oxid" (47) et dépôt sélectif de siliciure (33) sur les électrodes de grille (35,36) et sur les bornes de base et d'émetteur (37,28).

7. Procédé suivant l'une des revendications 4 à 6,
caractérisé en ce qu'on effectue, entre les phases opératoires i) et j), et après la technique photorésist antérieure, une implantation d'ions bore dans la zone des transistors MOS à canal n (B).

8. Procédé suivant les revendications 4 à 7,
caractérisé en ce qu'on utilise un substrat de silicium (1) dopé p et à orientation (100), possédant une résistance électrique spécifique de 20 Ohms cm.

9. Procédé suivant les revendications 4 et 7,
caractérisé en ce que l'on utilise un substrat de silicium (1) dopé p et à orientation (100), possédant une résistance électrique spécifique de 0,02 Ohm cm.

10. Procédé suivant l'une quelconque des revendications 5 à 9,
caractérisé en ce que la résistance électrique spécifique de la couche épitaxiale dopée p (7) est ajustée à 20 Ohms cm et l'épaisseur de couche est ajustée à environ 3 µm.

11. Procédé suivant l'une au moins des revendications 4 à 10,
caractérisé en ce que la réalisation de la couche isolante de flancs (39, 47) selon la phase opératoire o), est effectuée par décomposition thermique de l'orthosilicate-tétraéthyle (= TEOS).
